# EUROPEAN PATENT SPECIFICATION

(11) **EP 3 619 734 B1**
(45) Date of publication and mention of the grant of the patent: **17.03.2021**
(21) Application number: 18720257.7
(22) Date of filing: 27.04.2018
(51) Int. Cl.: H01J 37/32, C23C 16/54

(54) **LINEAR PLASMA SOURCE WITH SEGMENTED HOLLOW CATHODE**
LINEARE PLASMAQUELLE MIT SEGMENTIERTER HOHLKATHODE
SOURCE PLASMA LINÉAIRE À CATHODE CREUSE SEGMENTÉE

(30) Priority: 03.05.2017 EP 17169275
(43) Date of publication of application: 11.03.2020
(73) Proprietor: AGC Glass Europe, 1348 Louvain-La-Neuve (BE); AGC Inc., Tokyo 100-8405 (JP); AGC Glass Company North America, Alpharetta, GA 30022-1167 (US); AGC Vidros do Brasil Ltda, CEP 12523-671 Guaratinguetá São Paulo (BR)
(72) Inventor: WIAME, Hugues, 5537 Warnant (BE); CHAMBERS, John, San Francisco, California 94122 (US); DATZ, Marc, 37697 Lauenförde (DE)
(74) Representative: AGC Glass Europe
(86) International application number: PCT/EP2018/060922
(87) International publication number: WO 2018/202584

(56) References cited:
- WO-A1-2016/089424
- WO-A1-2016/089427
- WO-A2-01/73814
- US-A1- 2010 028 238

## Description

### FIELD OF THE INVENTION

The present invention relates generally to an electrode pair for generating a linear plasma wherein the electrodes are segmented. More particularly, the present invention relates to a plasma source, for instance a hollow-cathode plasma source, comprising one or more plasma-generating electrode pairs wherein the electrodes are segmented. The present invention further relates to methods for controlling the uniformity of a linear plasma and also to methods for surface treating or coating substrates in a uniform way with linear plasma sources.

### DISCUSSION OF THE BACKGROUND

Various plasma sources are disclosed in the prior art for the deposition of thin films and chemical modification, or surface treatment, of surfaces.

Linear plasmas may, however, have potential for more practical applications than point plasma sources. Linear plasma sources create a curtain of plasma that is usually placed perpendicular to the moving direction of the substrate to be treated. Linear plasmas can be made to work over large substrate surface areas (i.e. larger than 1 m²), which is useful for large area glass coating, web coating and multipart batch coating. Many known PECVD apparatuses are for small scale depositions (i.e. substrates smaller than 1 m²) since most plasma sources are very short and can only coat small areas.

When large substrates are to be treated, more suitable plasma sources typically are linear ionic sources like the one disclosed by Madocks in US7411352 B2. This plasma source is based on a magnetron discharge and produces a curtain of ions or, by combining several sources, multiple parallel curtains of ions directed towards the substrate surface. Madocks discloses that for coating purposes a coating precursor can be provided outside of the plasma sources. The plasma extends essentially only along one dimension, i.e. the length of plasma source. This plasma source relies on closed circuit electron drift to create a uniform plasma and is therefore quite complicated to build. Furthermore this plasma source necessitates magnets that are subject to damage from overheating.

Jung discloses in EP0727508 A1 a hollow cathode linear plasma source based on two parallel electrodes. The plasma extends essentially only along one dimension, i.e. the length of plasma source, forming a narrow plasma curtain Document WO2016/089427 A1 discloses a dual hollow cathode plasma source, wherein a hollow cathode is disposed in close proximity and aligned substantially parallel to a second hollow cathode. Each hollow cathode is comprised of electron emitting materials, and has a plasma exit orifice that is configured to face a substrate.

An improved plasma source is disclosed by Maschwitz in US2010/0028238 A1. It is a hollow cathode linear plasma source that does not rely on closed circuit electron drift to create a uniform plasma and is therefore less complicated to build. The Maschwitz plasma source comprises at least two electron emitting surfaces, or hollow cathodes, connected to each other via an AC power source, wherein the AC power source supplies a varying or alternating bipolar voltage to the two electron emitting surfaces. More specifically, the at least two electron emitting surfaces are connected to one another via an AC power source such that the AC power source applies a bipolar voltage difference to the two electron emitting surfaces. The bipolar power supply initially drives a first electron emitting surface to a negative voltage, allowing plasma formation, while the second electron emitting surface is driven to a positive voltage in order to serve as an anode for the voltage application circuit. The alternating power then drives the first electron emitting surface to a positive voltage and reverses the roles of cathode and anode. As one of the electron emitting surfaces is driven negative, a discharge forms within the corresponding cavity. The other electrode then serves as an anode, causing electrons to escape the plasma and travel to the anodic side, thereby completing an electric circuit. These hollow cathode based linear plasma sources provide a uniform plasma curtain over a length that may span over 2, 3 or even 4 m in length. They are therefore particularly well suited for treating large area substrates such as glass for example.

A condition for a uniform plasma curtain in elongated linear plasma sources such as cited hereinabove, in particular reaching 2, 3 or even 4 m in length, are uniformly machined electron emitting surfaces. However uniformly machining the necessary structures in a single piece reaching more than 2, 3 or even 4 m in length is very difficult and expensive.

Another condition for a uniform plasma curtain in such elongated linear plasma sources is the uniform distribution of the plasma forming gas and also, for coating processes, of the precursor gas. This uniform gas distribution is usually obtained by providing several gas inlets over the length of the linear plasma source, as well as a well-designed gas outlet of the plasma chamber, often in the form of a slot or a row of nozzles, whose flow restriction helps in the uniform distribution of plasma and gas. However the positions and dimensions of the gas inlets and outlets are fixed and cannot be modified without stopping the plasma coating or surface treatment process.

Another condition for a uniform plasma curtain in such elongated linear plasma sources is the temperature control over the length of the plasma source. However the amount heat generated in such plasma sources, reaching lengths of over 2, 3 or even 4 m, makes cooling without significant temperature differences difficult, putting strain on the equipment and possibly affecting the plasma process.

Industrial PECVD processes may run continuously for tens of hours or even several days. Over the course of such a production run, coatings may become non-uniform for various reasons. The outlets of the plasma source may for example be clogged by decomposing precursor molecules, or they may be widened by attack on the nozzle material by the plasma species. In such cases some adjustments of the gas flows are possible by controlling the gas flow rates at the different inlet points, these are however limited and may be insufficient.

Thus, there remains a need in the art for an improved hollow cathode linear PECVD source reaching over 2, 3 or even 4 m in length that avoids the uniformity problems of earlier-developed PECVD sources. Specifically, there is a need in the art for a linear hollow cathode plasma source reaching over 2, 3 or even 4 m in length, that is easy to manufacture, that can be cooled uniformly, and in which the plasma density and thus the uniformity of the coating, for instance its thickness or composition, or the uniformity of the surface treatment can be controlled dynamically over the width of a large substrate, for example glass, over prolonged production runs, without stopping the production.

### SUMMARY OF THE INVENTION

The previously mentioned linear plasma sources, in particular hollow cathode plasma sources, utilize control of the gas flow distribution over the length of the plasma source to control the uniformity of coating or surface treatment. The present invention improves upon previous linear plasma source designs, in particular hollow cathode plasma source designs, by providing control of the plasma density distribution as well as of the temperature over the length of the plasma source.

In the present invention a linear hollow cathode plasma source is provided wherein the first and second parallel linear electrodes, in between which the plasma is to be formed, are divided into pairs of electrode segments and wherein the plasma density can be controlled individually for each electrode segment pair and wherein each segment may be cooled individually Claim 1 defines an electrode pair comprising first and second equally segmented electrodes. Claim 11 defines a linear plasma source comprising at least one electrode pair according to claim 1. Claims 18-21 define a method of treating or coating a substrate surface, a method for continuously controlling the plasma density distribution over the length of a linear plasma source, a method for controlling the uniformity of a surface treatment and a method for continuously controlling the uniformity of a thin film deposition process, respectively, said methods providing a vacuum chamber that comprises the linear plasma source of claim 11.

### BRIEF DESCRIPTION OF THE DRAWINGS

FIG. 1 shows a prior art plasma source, which contains a pair of non-segmented electrodes.
FIG. 2 shows a pair of equally segmented electrodes.
FIG. 3 shows another pair of equally segmented electrodes FIG. 4 shows yet another pair of equally segmented electrodes.

### DETAILED DESCRIPTION OF THE INVENTION

While the present invention may be embodied in many different forms, a number of illustrative embodiments are described herein with the understanding that the present disclosure is to be considered as providing examples of the principles of the invention and such examples are not intended to limit the invention to preferred embodiments described and/or illustrated herein. The various embodiments are disclosed with sufficient detail to enable those skilled in the art to practice the invention. It is to be understood that other embodiments may be employed, and that structural and logical changes may be made without departing from the scope of the present invention.

As referred to herein, "plasma" is taken to mean an electrically conductive gaseous medium comprising both free electrons and positive ions. Traditionally, high intensity plasma of inert gas (e.g., argon, helium, krypton, neon, xenon) has been used during thin film coating processes. However, the increasing complexity and variety of thin film coatings has created a need for high intensity plasma comprising one or more reactive plasma forming gases such as oxygen and nitrogen. Plasmas may alternatively be formed using hydrogen or ammonia gas.

"Precursor gas" is taken to mean a gas in molecular form containing a chemical element or elements to be condensed into a solid coating. The elements to be condensed from the precursor gas may include metals, transition metals, boron, carbon, silicon, germanium and/or selenium. The choice of precursor gas is generally governed by several considerations, including stability at room temperature, ability to react cleanly in the reaction zone, and sufficient volatility at low temperature so that it can be easily transported to the reaction zone without condensing in the lines. Precursor molecules do not condense at the process pressure and temperature. In fact, a precursor molecule is unreactant or not prone to attaching on a surface until energized, partially decomposed, or fully decomposed by an energy source, whereupon a chemical fragment of the precursor gas containing the desired chemical element for coating becomes chemically able to bond to or condense upon a surface in a solid form. The condensed portion of the precursor compound may be primarily a pure element, a mixture of elements, a compound derived from the precursor compound constituents or a mixture of compounds. It is also possible to use a mixture of two or more precursor gases.

It is often desirable to deposit compounds on a surface which may not be chemically available from the precursor gas alone. Accordingly, "reactant gases" such as oxygen and nitrogen may be added to the CVD process to form oxides or nitrides. Other reactant gases include fluorine, chlorine, other halogens, nitric oxide, ammonia and hydrogen. A reactant gas may be differentiated from a precursor gas by the fact that even when energized or chemically decomposed, condensable molecular entities are not formed. Generally, reactant gases or reactant gas fragments cannot by themselves grow a solid deposition but they can react and become chemically incorporated into a solid deposition derived from precursor gases or other solid deposition sources. In many cases, the plasma gas acts as a reactant gas, and chemical fragments of plasma gas molecules become chemically incorporated into the deposited film. In other cases, a reactant gas may be provided separately from and in addition to the plasma gas.

"Chemical Vapor Deposition" or "CVD" is taken to mean the deposition of a film on a substrate from a chemical reaction in the vapor phase. In Plasma Enhanced Chemical Vapor Deposition or PECVD, a plasma-forming gas is chemically activated by supplying electrical power to the plasma-forming gas, generally at reduced pressures. The application of sufficiently high voltage causes breakdown of the plasma-forming gas, and a plasma appears, which consists of electrons, ions and electrically excited species. The energetic electrons in the plasma react with the plasma forming gas to form reactive species that serve to perform surface treatments or to decompose precursor gas molecules so that a coating can be formed.

"Dark space" is taken to mean a narrow zone or area around an electrode wherein plasma current is very low. Generally, two oppositely charged plasma electrodes or a plasma electrode and a ground potential conductor spaced apart by a dark space distance will exhibit substantially no current flow between them.

"Hollow Cathode" is taken to mean an electrode typically comprised of an electron-emitting surface that defines a cavity. Hollow cathode cavities may be formed in many shapes. In the present invention they are of elongated shape, having a preferably constant cross-section that may be rectangular, rounded rectangular (i.e. rectangular with rounded corners or edges), circular, oblong, elliptical, or oval. Hollow cathodes typically comprise on or more inlet(s) for plasma and/or reactant gas, and one or more plasma outlet(s). The plasma outlet may for example be shaped as a slit or an array of holes along a length of the hollow cathode essentially facing the substrate to be treated. The inlet for plasma and/or reactant gas is preferably situated essentially along the length of the hollow cathode opposite the plasma outlet. Hollow cathodes can be connected to a source of alternating current, such that the polarity of the electrode alternates between positive (anode) and negative (cathode). When the electron-emitting surface of a hollow cathode has a negative potential, electrons oscillate in the cavity and are thereby confined within the cavity.

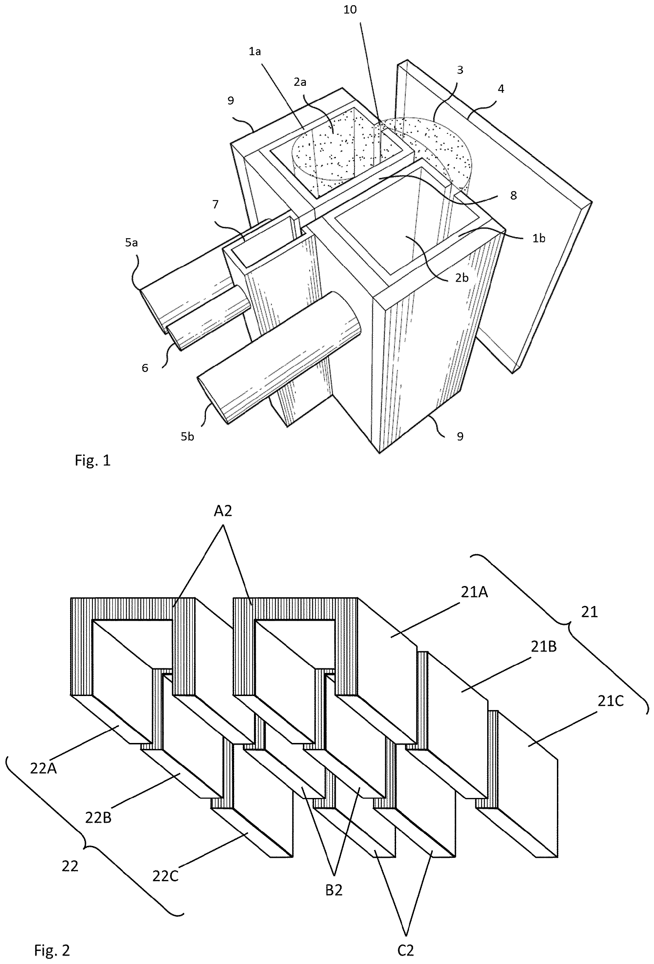

"Hollow cathode plasma source," is taken to mean a plasma or ion source comprising one or more electrodes configured to produce hollow cathode discharges. One example of a hollow cathode plasma source is described in commonly-owned U.S. Pat. No. 8,652,586 to Maschwitz ("Maschwitz '586"). FIG. 1 shows a prior art hollow cathode plasma source similar to that disclosed in Maschwitz '586. The plasma source comprises at least two hollow cathode electrodes 1a and 1b, arranged in parallel and connected via an AC power source (not shown). Electrically insulating material 9 is disposed around the hollow cathode electrodes. The plasma forming gas is supplied via the inlets 5a and 5b. When used, the precursor gas is supplied via the precursor gas inlet 6 and led through manifold 7 and precursor injection slot 8 in the dark space between the electrodes, into the plasma curtain 3. The AC power source supplies a varying or alternating bipolar voltage to the two electrodes. The AC power supply initially drives the first electrode to a negative voltage, allowing plasma formation, while the second electrode is driven to a positive voltage in order to serve as an anode for the voltage application circuit. This then drives the first electrode to a positive voltage and reverses the roles of cathode and anode. As one of the electrodes is driven negative 1a, a discharge 2a forms within the corresponding cavity. The other electrode then forms an anode, causing electrons to escape the plasma through the outlet 10 and travel to the anodic side, thereby completing an electric circuit. A plasma curtain 3 is thus formed in the region between the first and the second electrodes above the substrate 4. This method of driving hollow cathodes with AC power contributes formation of a uniform linear plasma. For the purpose of the present patent, the electron emitting surfaces may also be called plasma generating surfaces.

"Substrate" is taken to mean either a small area or large area item to be coated or have its surface physically and/or chemically modified by this invention. A substrate, as referred to herein, can be comprised of glass, plastic, metal, inorganic materials, organic materials or any other material that has a surface to be coated or modified.

"Closed circuit electron drift" is taken to mean an electron current caused by crossed electric and magnetic fields. In many conventional plasma forming devices the closed circuit electron drift forms a closed circulating path or "racetrack" of electron flow.

"AC power" is taken to mean electric power from an alternating source wherein the voltage is changing at some frequency in a manner that is sinusoidal, square wave, pulsed or some other waveform. Voltage variations are often from negative to positive, i.e. with respect to ground. When in bipolar form, power output delivered by two leads is generally about 180° out of phase.

"Electrodes" provide free electrons during the generation of a plasma, for example, while they are connected to a power supply providing a voltage. The electron-emitting surfaces of a hollow cathode are considered, in combination, to be one electrode. Electrodes can be made from materials well-known to those of skill in the art, such as steel, stainless steel, copper, or aluminum. However, these materials must be carefully selected for each plasma-enhanced process, as different gasses may require different electrode materials to ignite and maintain a plasma during operation. It is also possible to improve the performance and/or durability of the electrodes by providing them with a coating.

"Thin film" or "thin film coating" or "thin film stack" refers to one or more microscopically thin layers deposited on a substrate. Thin film coatings are incorporated into many modern devices such as low emissivity ("low E") windows, semiconductor chips, photovoltaic devices, machine tools, and automotive components in order to maximize their performance and service life.

"Surface modification" or "surface treatment" is taken to mean one or more processes performed on a substrate including heat treatment, coated layer heat annealing, surface cleaning, surface chemical functionalization, crystal structure modification of coated layers, ion bombardment, and ion implantation.

The disclosed embodiments address the need for effective control over the thickness of a deposited coating, particularly in systems containing elongated hollow cathode for coating large glass substrates.

In one or more aspects of the invention, there is provided an electrode pair comprising first and second equally segmented electrodes, wherein the first and second equally segmented electrodes
a. have the desired morphology and composition for electron emission and plasma generation and stability,
b. are elongated along a lengthwise direction,
c. are of essentially identical elongated shape and size and adjacent to each other with their lengthwise directions in parallel to each other,
d. are each divided perpendicularly to their length into the same number of at least two segments, wherein
   i. each segment of the first electrode faces an equally sized segment of the second electrode, and
   ii. each segment of the first electrode and its facing segment of the second electrode forms a pair of electrode segments.

Fig. 2 shows an electrode pair in accordance with the present invention, having a first electrode (21) and a second electrode (22). The first and second electrodes are equally divided into segments (21A, 21B, 21C and 22A, 22B, 22C). Respectively facing segments (21A and 22A; 21B and 22B; 21C and 22C) are equally sized, that is they have the same size in terms of cross section and length. These respectively facing segments each form a pair of electrode segments (A2, B2, C2). The first and second equally segmented electrodes morphology is such that they respectively enclose separate first and second cavities. Each cavity is enclosed by the respective electrode on three sides. A plasma may generated within each cavity. First and second equally segmented electrodes are configured to span a flat substrate, adjacently, side by side, each segmented electrode keeping the same distance from the flat substrate. First and second electrode, segmented in this way, are termed first and second equally segmented electrodes for the purpose of this disclosure. The first and second equally segmented electrodes are also provided with separate first and second inlets for plasma forming gas and optionally for reactant gas. These inlets are not shown in the present figure. The first and second electrodes are comprised of electron emitting materials. Electrically insulating material is disposed around the first and second electrodes and restricts the plasma from travelling outside of the electrodes to the environment (not shown).

Such an electrode pair, comprising first and second equally segmented electrodes as described hereinabove, was found by the inventors to be much easier to machine and assemble and the segmentation and the resulting non-continuous electron emitting surfaces surprisingly did not affect the plasma formation of the hollow cathode plasma source comprising these segmented electrodes in any noticeable degree even for a linear plasma reaching more than 2, 3 or even 4 m in length.

The first and second equally segmented electrodes are adjacent to each other with their lengthwise directions in parallel to each other. The position of the first and of the second equally segmented electrodes is configured for being placed equidistantly from a flat substrate to be surface treated or coated. The plasma they generate being used to surface treat or coat said flat substrate surface. In other words the electrode pair of the present invention is an electrode pair for surface treating or coating a flat substrate, comprising first and second equally segmented electrodes configured to be positioned equidistantly from said flat substrate. First and second segmented electrodes span the flat substrate in an equidistant way, that is the distance between the flat substrate and the first segmented electrode is the same as the distance between the substrate and the second segmented electrode.

In particular the first and second equally segmented electrodes morphology is such that they respectively enclose separate first and second cavities. Furthermore they may respectively be provided with separate first and a second gas inlets for the plasma forming gas and are respectively provided with separate first and second gas outlets which may for example lead respectively to first and second outlet nozzles which may be directed towards a substrate. The first and second cavities' cross section may be of rectangular, rounded rectangular or circular shape or of a shape intermediary of these shapes and the first and second cavities' cross section area may be comprised between 500 mm² and 4000 mm², and the cavity distance, that is the shortest distance in between the first and the second gas outlet or the first and second outlet nozzle may be comprised between 85 mm and 160 mm. The first and second outlet nozzle width may be comprised between 1 mm and 25 mm.

In another embodiment, one or more electrode segments of the equally segmented electrodes comprise two electrode sub-segments, so that they can be split lengthwise in half. It was found by the inventors, that this further simplifies manufacture and maintenance while still permitting the formation of a linear plasma reaching more than 2, 3 or even 4 m in length.

The equally segmented electrodes may benefit any type of plasma source. The first and second equally segmented electrodes have the desired morphology and composition for generating a hollow cathode plasma within the space enclosed by each electrode segment. The plasma is generated by electron oscillation that takes place within the space enclosed by each electrode segment, while a secondary electron current flows through the plasma gas outlets, throughout the gas space separating the outlets of each pair of electrode segment. Thus a plasma curtain extends between the first and second segmented electrodes.

The main parameters of an electrode segment's size are its transverse cross-section, in particular the shape and dimensions of its cross-section, as well as its length, in particular the length of the volume it encloses. Equally sized segments have essentially the same cross-section and the same length. The number of segments and their lengths are determined by the overall length of the first and second electrodes as well as by the coating deposition uniformity requirements, by the surface treatment uniformity requirements and/or by the cooling uniformity requirements. For a uniform linear plasma reaching more than 2, 3 or even 4 m in length each electrode is divided in at least two, preferably at least three, more preferably in at least four, most preferably in at least five segments.

According to an embodiment of the present invention the electrode segments' transverse cross-section area is comprised between 100mm² and 10000mm², preferably between 500mm² and 4000mm².

According to an embodiment of the present invention the electrode segments' transverse cross section is of rectangular, rounded rectangular or circular shape or of a shape intermediary of these shapes.

Different segmentations and electrical connections can be combined in order to obtain plasma uniformity control in the relevant areas for each specific process.

According to the present invention, the first and second electrodes may each be divided perpendicularly to their length into the same number of segments, each segment of the first electrode facing an equally sized segment of the second electrode, forming a pair of electrode segments, wherein the size of all pairs of electrode segments is the same. This further simplifies the electrode manufacturing process.

According to the present invention, the first and second electrodes may each be divided perpendicularly to their length into the same number of segments, each segment of the first electrode facing an equally sized segment of the second electrode, forming a pair of electrode segments, wherein the size of at least one pair of electrode segments is different from the size of at least one other pair of electrode segments. Preferably the two pairs of electrode segments having a different size differ essentially only in length while having essentially the same cross-section. In this way the size of the segments can be adapted to areas where independent plasma control is necessary.

According to an embodiment of the present invention electrically insulating material is provided in between the neighboring segments of at least two pairs of electrode segments so that the electrode segments of at least one pair of electrode segments are not in direct electrical contact with the electrode segments of a neighboring pairs of electrode segments. According to a more preferred embodiment of the present invention electrically insulating material is provided in between all the electrode segments of the first and second equally segmented electrodes so that no neighboring electrode segments are in direct electrical contact with each other. The electrically insulating material prevents current flowing through it between neighboring segments and is preferably configured so as not to extend into the space enclosed by each electrode, to prevent perturbing the plasma and/or the gas flow.

In another embodiment of the present invention, dark space is provided in between the neighboring segments of at least two pairs of electrode segments so that the electrode segments of at least one pair of electrode segments are not in direct electrical contact with the electrode segments of a neighboring pairs of electrode segments. According to a more preferred embodiment of the present invention dark space is provided in between all the electrode segments of the first and second equally segmented electrodes so that no neighboring electrode segments are in direct electrical contact with each other. The dark space prevents current flowing through it between neighboring segments. Its thickness, that is the minimum distance it spans in between the neighboring segments is set depending on the pressure in the hollow cathode cavity. It is preferably comprised between 0.1 and 1mm, more preferably between 0.2 and 0.5 mm.

Most surprisingly, such an electrode pair, comprising first and second equally segmented electrodes, wherein the segments of the first and second electrode respectively are not in direct contact with each other, was found by the inventors to be able to form a continuous plasma without any noticeable disturbance, even for a linear plasma reaching more than 2, 3 or even 4 m in length. Furthermore it was found, that by controlling the supplied power, the plasma density between the facing segments of each pair of electrode segments could be controlled individually.

According to the present invention neighboring electrode segments may be spaced apart by 0.1 to 10 mm, preferably by 0.1 to 5 mm, more preferably by 0.5 to 3 mm.

In one or more other aspects of the invention, the pair of equally segmented electrodes is positioned in a hollow cathode linear plasma source.

In one or more other aspects of the invention, there is provided a hollow cathode linear plasma source, wherein the linear plasma source comprises at least one electrode pair according to the present invention, and wherein the at least one electrode pair's first and second equally segmented electrodes have the desired morphology and composition for generating a hollow cathode plasma within the space enclosed by each electrode. The linear hollow cathode plasma source of the present invention does not depend on closed circuit electron drift to create a uniform plasma.

According to an embodiment of the present invention, the linear plasma source also comprises a source of power capable of supplying electrical power for the electrode pair to generate a hollow cathode plasma.

According to an embodiment of the present invention one or more pair(s) of electrode segments may be supplied with electrical power from one or more power sources, typically AC power sources supplying a varying or alternating bipolar voltage, providing a voltage that alternates between positive and negative to generate a plasma proximate to the plasma-generating surfaces of the supplied pairs of electrode segments.

According to an embodiment of the present invention every pair of electrode segments is supplied from one or more power sources with the same electrical power, that is electrical power with a voltage that alternates in the same way for every pair of electrode segments between positive and negative to generate a plasma, preferably a hollow cathode plasma, proximate to the plasma-generating surfaces of the supplied pairs of electrode segments.

According to another embodiment of the present invention, each pair of electrode segments may be supplied with electrical power from an individual power source, each electrode segment is thus supplied with its individual electrical power. It is also possible for two or more pairs of electrode segments to share the same power source.

In another embodiment of the present invention, the electrical power is supplied from a single power source to all pairs of electrode segments.

According to the present invention at least one pair of electrode segments may be supplied with one electrical power and at least one other pair of electrode segments may be supplied with one other electrical power, wherein the one and one other electrical power have voltages that alternate, between positive and negative to generate plasmas proximate to the plasma-generating surfaces of the supplied pairs of electrode segments. The one and one other electrical powers may differ at least regarding their powers, voltages, currents, phases and/or frequencies. Preferably the one electrical power and one other electrical power can be controlled individually and independently. Independently controlling a supplied electrical power independently means its different parameters, comprising at least power, voltage, current, phases and/or frequency, can be set independently from one other electrical power. In a preferred embodiment every pair of electrode segments is individually supplied with electrical power, wherein the individual supply of electrical power can be controlled independently for each pair of electrode segments.

There are many ways to supply a pair of electrode segments with the desired electrical power. For instance, each pair of electrode segments may be electrically connected to an individual power source having the necessary means, for example an electrical circuit, for providing the desired electrical power. It is also possible to supply more than one pair of electrode segments, even all pairs of electrode segments, from a single power source having the necessary electrical circuit for providing each pair of electrode segments with its individual desired electrical power.

It was surprisingly found that thus equally segmented pairs of electrodes, having at least one pair of electrode segments supplied with one electrical power and at least one other pair of electrode segments supplied with one other electrical power, is able to form a linear plasma whose plasma density in between the at least one pair of electrode segments is different from the plasma density in between the at least one other pair of electrode segments. Alternatively the plasma density in between the at least one pair of electrode segments and the at least one other pair of electrode segments can be made the same with different electrical powers supplied, for example to compensate for other parameters that induce differences, or non-uniformities, in the plasma density. Furthermore the power supplied each pair of electrode segments may be continuously modifiable so as to control the plasma density of each electrode segment pair over the duration of a production run, without stopping the plasma coating or surface treatment process. By controlling the plasma density of one or more electrode segment pairs in this way, the coating deposition uniformity or surface treatment uniformity may be controlled continuously over the duration of a production run in particular for a linear plasma reaching more than 2, 3 or even 4 m in length. In a particular embodiment, by controlling the plasma density of one or more electrode segment pairs in this way, non-uniformities or gradients of the coating deposition or surface treatment over the width of the substrate may be intentionally produced.

According to another embodiment of the present invention one or more pairs of electrode segments are supplied with electrical power from one power source while one or more other pairs of electrode segments are supplied with electrical power from another power source.

According to another embodiment of the present invention every pair of electrode segments supplied with electrical power from a power source that is an individual power source, a power source that is different from every other pair of electrode segment's power source.

According to another embodiment of the present invention every pair of electrode segments is supplied with electrical power from one or more power sources having the necessary circuitry for providing each pair of electrode segments with its individual electrical power, that is electrical power that is controlled separately from every other pair of electrode segment's electrical power.

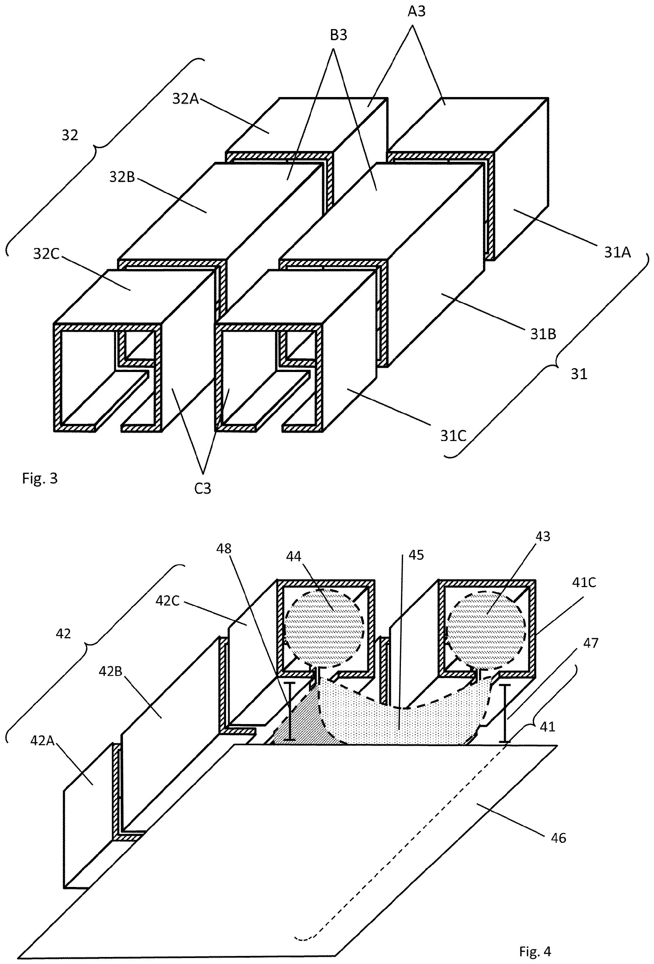

Fig. 3 shows another pair of equally segmented electrodes, a first electrode (31) and a second electrode (32). The first and second electrodes are equally divided into segments (31A, 31B, 31C and 32A, 32B, 32C). Respectively facing segments (31A and 32A; 31B and 32B; 31C and 32C) have the same size and form a pair of electrode segments (A3, B3, C3). The first and second equally segmented electrodes morphology is such that they respectively enclose separate first and second cavities. Each cavity is enclosed by the respective electrode on four sides, leaving an opening, or outlet on one side which is to be oriented towards the substrate to be surface treated or coated.. The size of the pair of electrode segments B3 is in this case different from the size of the pairs of electrode segments A3 and C3. The individual power sources connecting facing segments (31A and 32A, 31B and 32B, 31C and 32C) are not shown. Inlets for plasma forming gas and optional precursor gas are not shown.

Fig. 4 shows another pair of equally segmented electrodes, similar to the one in Fig. 3, with a first electrode (41), partially hidden by the flat substrate 46) to be surface treated or coated, and a second electrode (42). The first and second electrodes are equally divided into segments (41A, 41B, 41C and 42A, 42B, 42C). Segments 41A and 41B are not shown as they are hidden from view by the flat substrate (46). Respectively facing segments (31A and 32A; 31B and 32B; 31C and 32C) have the same size and form a pair of electrode segments (A3, B3, C3). The first and second equally segmented electrodes morphology is such that they respectively enclose separate first and second cavities. Each cavity is enclosed by the respective electrode on four sides, leaving an opening, or outlet on one side which is to be oriented towards the substrate to be surface treated or coated. First (43) and second (44) plasmas are generate within the respective cavities of the first and second electrodes, extending in between the outlets of the electrodes (45). The distance (47) between the first segmented electrode (41) and the flat substrate (46) is the same as the distance (48) between the second segmented electrode (42) and the flat substrate (46) The size of the pair of electrode segments B3 is in this case different from the size of the pairs of electrode segments A3 and C3. The individual power sources connecting facing segments (31A and 32A, 31B and 32B, 31C and 32C) are not shown. Inlets for plasma forming gas and optional precursor gas are not shown.

Depending on the requirements of the plasma deposition or surface treatment process, it was found that the uniformity for a linear plasma reaching more than 2, 3 or even 4 m in length could be controlled by varying the electrical power supplied to the pairs of electrode segments. The power supplied to each electrode segment pair could be varied with regard to power (that is the product of current x voltage), current, voltage, frequency, and/or phase.

The electrical power supplied to a pair of electrode segments, in particular for a hollow cathode plasma, can typically be varied between 1 and 100 kW per meter of plasma length, preferably between 5 and 60 kW per meter of plasma length, more preferably between 10 and 40 kW per meter of plasma length. The plasma length of a pair of electrode segments is defined as the distance between the ends of the linear plasma generated by this pair of electrode segments. For the purpose of the present invention, the power density of the plasma is defined as the total power supplied to a pair of electrode segments, divided by the total length of the plasma.

The frequency of the electrical current supplied to a pair of electrode segments, in particular for a hollow cathode plasma source, is typically between 5 and 150 kHz, preferably between 5 and 100 kHz.

In one or more other aspects of the invention, there is provided a method for continuously controlling the plasma density distribution over the length of a linear plasma source.

The method for controlling the plasma density distribution over the length of a linear plasma source comprises:
a. providing a hollow cathode plasma source comprising at least one pair of equally segmented electrodes according to the present invention,
b. injecting a plasma forming gas through the equally segmented electrodes' plasma forming gas inlets,
c. supplying electrical power to one and at least one other pair of electrode segments so as to generate a plasma curtain in between their respective outlets,
d. setting the parameters of the electrical power supplied to the one pair of electrode segments independently of the parameters of the electrical power supplied to the at least one other pair of electrode segments.

The plasma density distribution may be measured, continuously or periodically, and the parameters of the supplied electrical powers adapted so as to correct non-uniformities.

According to an embodiment of the present invention, the pair of segmented electrodes further comprises at least one pair of blanks. The pair of blanks comprises a first blank of the first segmented electrode facing an equally sized second blank of the second segmented electrode. It was found that by placing one or more pairs of blanks at one or both ends of the plasma source, the overall length of the plasma source could thus be adapted to the width of a substrate to be treated or to the selected area of the substrate to be treated. Furthermore it was found that by placing one or more pairs of blanks at other positions than at the ends of the plasma source, the linear plasma source could be interrupted in selected areas. According to the present invention, a blank is preferably of the same material as the electrode segments and has no hollow cathode cavity cutout and is not connected to a power source. Blanks are preferably also provided with cooling means. Shields and insulation are adjusted to simply insulate around the unused section of electrode. Gas inlets and gas outlets are preferably adapted to the placement of the blanks.

According to the present invention, each electrode segment may be provided with means for cooling, for example by a coolant such as water. In a preferred embodiment of the present invention, at least one electrode segment is provided with dedicated means for cooling, that is controlled separately from at least one other means of cooling of one other electrode segment. The means for cooling may for example comprise coolant circuits, for example water circuits, attached to the electrode segments or integrated within the body of the electrode segments. Dedicated means for cooling, for example by water, may be fed from dedicated connections to a master cooling circuit. In a more preferred embodiment of the present invention, each electrode segment may be provided with dedicated means for cooling by water or other cooling methods.

The inventors have found that the temperature of the electrode segments influences among others the wear of the electrodes during operation. Uneven wear of the electrodes was found to lead to non-uniformities in the surface treatment and/or surface coating of substrates and even to the formation of debris by reactions of the plasma and the electrode material itself. It was surprisingly found that the electrode segments of the equally segmented electrodes of the present invention are apparently subjected to different heat loads, depending on their position, and that by controlling the cooling separately for different segments, local overheating could be avoided and thus minimizing non-uniformities in the surface treatment and/or surface coating as well as the formation of debris.

Preferably the plasma source comprises one or more inlets for precursor gas. These precursor gas inlets preferably direct and uniformly distribute the precursor gas towards the plasma that is formed in between the outlets of pairs of electrode segments. The highest coating deposition rates were found with such a configuration. When used, the precursor gas is preferably supplied via a precursor gas inlet and led through a precursor injection slot between the plasma forming electrodes.

In one or more other aspects of the invention, there is provided a method for performing a surface treatment of a substrate using a hollow cathode plasma source incorporating one or more pairs of equally segmented electrodes of the present invention.

The method of treating a substrate surface comprises:
a. providing a vacuum chamber comprising a hollow cathode plasma source comprising at least one pair of equally segmented electrodes according to the present invention,
b. injecting a plasma forming gas through the equally segmented electrodes' plasma forming gas inlets,
c. supplying electrical power to one or more pairs of electrode segments so as to generate a plasma curtain in between their respective outlets,
d. introducing a substrate into the generated plasma curtain(s).

The pressure in the vacuum chamber is typically comprised between 0.5 and 0.001 Torr, preferably between 1 and 30 mTorr and more preferably between 3 and 20 mTorr.

In one or more other aspects of the invention, there is provided a method for depositing a thin film coating on a substrate using a hollow cathode plasma source incorporating one or more pairs of equally segmented electrodes.

The method for depositing a thin film coating on a substrate comprises:
a. providing a vacuum chamber comprising a hollow cathode plasma source comprising at least one pair of equally segmented electrodes according to the present invention,
b. injecting a plasma forming gas through the equally segmented electrodes' plasma forming gas inlets,
c. supplying electrical power to one or more pairs of electrode segments so as to generate a plasma curtain in between their respective outlets,
d. injecting a coating precursor gas into the generated plasma curtain(s),
e. introducing a substrate into the generated plasma curtain(s),
f. depositing a coating from the precursor gas activated by the generated plasma curtain(s).

Although the methods for performing a surface treatment and for depositing a thin film using one or more pairs of equally segmented electrodes of the present invention is particularly directed to electrodes having the desired morphology and composition for generating a hollow cathode plasma, they may also be performed using equally segmented electrodes generating a plasma which is not a hollow cathode plasma.

In one or more other aspects of the invention, there is provided a method for controlling the uniformity of a thin film deposition process or surface treatment over the length of a process run.

The method for controlling the surface treatment comprises:
a. providing a hollow cathode plasma source comprising at least one pair of equally segmented electrodes according to the present invention,
b. injecting a plasma forming gas through the equally segmented electrodes' plasma forming gas inlets,
c. supplying electrical power to one and at least one other pair of electrode segments so as to generate a plasma curtain in between their respective outlets,
d. setting the parameters of the electrical power supplied to the one pair of electrode segments independently of the parameters of the electrical power supplied to the at least one other pair of electrode segments,
e. introducing a substrate into the plasma thus generated in between the outlets of the one or more pairs of electrode segments,

The method for controlling a coating deposition comprises:
a. injecting a plasma forming gas through the equally segmented electrodes' plasma forming gas inlets,
b. supplying electrical power to one and at least one other pair of electrode segments so as to generate a plasma curtain in between their respective outlets,
c. setting the parameters of the electrical power supplied to the one pair of electrode segments independently of the parameters of the electrical power supplied to the at least one other pair of electrode segments,
d. directing a precursor gas towards the generated plasma curtains,
e. introducing a substrate into the generated plasma curtains..

The method for controlling the uniformity of a surface treatment or of a coating deposition preferably further comprises measuring the uniformity of the surface treatment or coating deposition (continuously or periodically), determining the difference between the measured uniformity and the desired uniformity and adapting the parameters of the supplied electrical powers so as to compensate the difference between the desired uniformity and the measured uniformity.

The uniformity of a surface treatment or coating may be measured by any appropriate measurement method known to the person skilled in the art, as exemplified hereafter. Coating deposition, heat treatment, coated layer heat annealing, surface cleaning, surface chemical functionalization, crystal structure modification of coated layers, ion bombardments, and ion implantations frequently modifies the optical properties of a treated substrate. Measurement of transmittance, reflectance and or absorption may for example be used to determine the uniformity of a surface treatment or coating. When surface treatments or coatings modify the wettability of a surface, water contact angle measurements may for example be used. The modification of crystallinity may be determined with x-ray diffraction or X-ray reflectometry measurements. Electrical conductivity measurements may be made using four-point probe measurement devices or indirectly by using a non-contact eddy current based testing device.

In one or more other aspects of the disclosure, there is provided a coating deposited on a substrate, wherein the coating is deposited using a pair of equally segmented electrodes.

These and other aspects are achieved, in accordance with embodiments of the invention, by providing a pair of equally segmented electrodes positioned in a plasma source device, the electrode pair having a first and a second electrode, comprising a first and a second plasma-generating surface respectively. Each electrode is divided perpendicularly to its length into the same number of electrically isolated segments, each segment of the first electrode facing an equally sized segment of the second electrode, forming a pair of electrode segments. The segments of each pair of electrode segments being connected to a dedicated power source.

These and other objects and features of the present invention will be apparent from the written description and drawings presented herein.

In an embodiment of the invention, a plasma source is provided. The plasma source comprises a pair of equally segmented electrodes, the electrode pair having a first electrode and a second electrode separated by a gas containing space. Each pair of electrode segments is electrically connected to a power source, which is configured to supply a voltage that alternates between positive and negative to cause the voltage supplied to the segment of the first electrode to be out of phase with the voltage supplied to the segment of the second electrode, creating a current that flows between these electrode segments. The current creates a plasma between these electrode segments that is substantially uniform over the segment pair's length in the substantial absence of closed-circuit electron drift. In this source, each pair of electrode segments is connected to a separate dedicated power source. The voltage, current, power, frequency or phase supplied to each pair of electrode segments can thus be at individually controlled. The plasma created by each pair of electrode segments can thus also be individually controlled, in particular the plasma density can be controlled.

The plasma source, in some embodiments of the invention, may be configured to deposit a coating using plasma enhanced chemical vapor deposition (PECVD). When configured for PECVD, a gas inlet configured to supply a precursor gas and a gas inlet configured to supply a reactant gas are included. The precursor gas is activated by the plasma. A substrate is conveyed adjacent to the source, and a thin film is deposited on the substrate from the activated gas.

The plasma source, in some embodiments of the invention, may be configured to plasma treat the surface of a substrate. When configured for surface treatment a substrate is conveyed adjacent to the source, and the surface treatment is performed by the plasma coming into contact with the substrate..

The resulting surface treatment or coating deposition can thus also be controlled by controlling the plasma density distribution of the hollow cathode plasma source.

The inventors of the subject matter described herein have found that when incorporated into a plasma source, pairs of equally segmented electrodes serve to improve the uniformity over the length of the plasma they generate. This results in more uniform coating depositions or surface treatments. An additional benefit is that the manufacture and assembly of electrodes stretching over an overall length of more than 1 m is made much easier when the electrodes are assembled from individual segments The invention is defined by the claims.

## Claims

1. Electrode pair comprising first and second equally segmented electrodes (21,22), wherein the first and second equally segmented electrodes (21,22)
a. have the desired morphology and composition for electron emission and plasma generation and stability,
i. the generated plasma being a hollow cathode plasma,
b. are elongated along a lengthwise direction,
c. are of essentially identical elongated shape and size and adjacent to each other with their lengthwise directions in parallel to each other,
d. are each divided perpendicularly to their length into the same number of at least two segments (21A, 21B, 21C and 22A, 22B, 22C), wherein
i. each segment of the first electrode (21A, 21B, 21C) faces an equally sized segment of the second electrode (22A, 22B, 22C), and
ii. each segment of the first electrode and its facing segment (21A and 22A; 21B and 22B; 21C and 22C) of the second electrode forms a pair of electrode segments (A2, B2, C2).

2. Electrode pair according to claim 1 wherein the size of the segments of at least one pair of electrode segments (B3) is different from the size of the electrode segments of at least one other pair of segments (A3, C3).

3. Electrode pair according to claim 1 wherein the size of all electrode segments (A2, B2, C2) is the same.

4. Electrode pair according to claims 1 to 3 wherein electrically insulating material or dark space is provided in between the neighboring segments of at least one pair of neighboring electrode segments.

5. Electrode pair according to claims 1 to 4 wherein all the segments of the first and second equally segmented electrodes are not in direct electrical contact with each other.

6. Electrode pair according to claims 1 to 5 wherein the first and second equally segmented electrodes are provided with means for cooling.

7. Electrode pair according to claims 1 to 6 wherein at least one electrode segment is provided with means of cooling that is separate from at least one other means of cooling of another electrode segment.

8. Electrode pair according to claims 1 to 7 wherein the first and second segmented electrodes comprise at least one pair of blanks.

9. Electrode pair according to claims 1 to 8 wherein at least one electrode segment is provided with dedicated means for cooling.

10. Electrode pair according to claims 1 to 9 wherein at least one electrode segment of the equally segmented electrodes comprises two electrode sub-segments.

11. Hollow cathode linear plasma source comprising at least one electrode pair according to claims 1 to 10.

12. Hollow cathode linear plasma source according to claim 11 comprising one or more power sources supplying one or more pairs of electrode segments with an electrical power.

13. Hollow cathode linear plasma source according to claim 12 comprising one power source supplying each pair of electrode segments with an electrical power.

14. Hollow cathode linear plasma source according to claim 12 comprising for each pair of electrode segments an individual power source supplying each electrode segment with an individual electrical power.

15. Hollow cathode linear plasma source according to claims 11 to 14 wherein at least one electrode segment is provided with dedicated means of cooling that is controlled separately from at least one other means of cooling of one other electrode segment.

16. Hollow cathode linear plasma source according to claims 12 to 15 wherein at least one pair of electrode segments is supplied with one electrical power and at least one other pair of electrode segments is supplied with one other electrical power.

17. Hollow cathode linear plasma source according to claims 12 to 15 wherein every pair of electrode segments is supplied with the same electrical power.

18. Method of treating or coating a substrate surface, comprising:
a. providing a vacuum chamber comprising a hollow cathode linear plasma source according to claims 11 to 17,
b. injecting a plasma forming gas through the plasma source's equally segmented electrodes' plasma forming gas inlets,
c. supplying electrical power to one or more pairs of electrode segments so as to generate a plasma curtain in between their respective outlets,
d. optionally injecting a coating precursor gas into the generated plasma curtain(s),
e. introducing a substrate into the generated plasma curtain(s).

19. Method for continuously controlling the plasma density distribution over the length of a linear plasma source comprising:
a. providing a vacuum chamber comprising a hollow cathode linear plasma source according to claims 11 to 16,
b. injecting a plasma forming gas through the plasma source's equally segmented electrodes' plasma forming gas inlets,
c. supplying electrical power to one and at least one other pair of electrode segments so as to generate plasma curtains in between their respective outlets,
d. setting the parameters of the electrical power supplied to the one pair of electrode segments independently of the parameters of the electrical power supplied to the at least one other pair of electrode segments.

20. Method for controlling the uniformity of a surface treatment comprising:
a. providing a vacuum chamber comprising a hollow cathode linear plasma source according to claims 11 to 16,
b. injecting a plasma forming gas through the equally segmented electrodes' plasma forming gas inlets,
c. supplying electrical power to one and at least one other pair of electrode segments so as to generate a plasma curtain in between their respective outlets,
d. setting the parameters of the electrical power supplied to the one pair of electrode segments independently of the parameters of the electrical power supplied to the at least one other pair of electrode segments,
e. introducing a substrate into the generated plasma curtains.

21. Method for continuously controlling the uniformity of a thin film deposition process comprising:
a. providing a vacuum chamber comprising a hollow cathode linear plasma source according to claims 11 to 16,
b. injecting a plasma forming gas through the equally segmented electrodes' plasma forming gas inlets,
c. supplying electrical power to one and at least one other pair of electrode segments so as to generate a plasma curtain in between their respective outlets,
d. setting the parameters of the electrical power supplied to the one pair of electrode segments independently of the parameters of the electrical power supplied to the at least one other pair of electrode segments,
e. directing a precursor gas towards the generated plasma curtains,
f. introducing a substrate into the generated plasma curtains.

## Patentansprüche

1. Elektrodenpaar, das eine erste und eine zweite gleichartig segmentierte Elektrode (21, 22) umfasst, wobei die erste und die zweite gleichartig segmentierte Elektrode (21, 22)
a. die gewünschte Morphologie und Zusammensetzung für Elektronenemission und Plasmaerzeugung und -stabilität aufweisen,
i. wobei das erzeugte Plasma ein Hohlkathodenplasma ist,
b. entlang einer Längsrichtung länglich sind,
c. von im Wesentlichen identischer länglicher Gestalt und Größe sind und mit ihren Längsrichtungen parallel zueinander aneinander angrenzen,
d. jeweils senkrecht zu ihrer Länge in dieselbe Anzahl von mindestens zwei Segmenten (21A, 21B, 21C und 22A, 22B, 22C) aufgeteilt sind, wobei
i. jedes Segment der ersten Elektrode (21A, 21B, 21C) einem gleichgroßen Segment der zweiten Elektrode (22A, 22B, 22C) zugewandt ist, und
ii. jedes Segment der ersten Elektrode und dessen zugewandtes Segment (21A und 22A; 21B und 22B; 21C und 22C) der zweiten Elektrode ein Paar von Elektrodensegmenten (A2, B2, C2) ausbildet.

2. Elektrodenpaar nach Anspruch 1, wobei sich die Größe der Segmente von mindestens einem Paar von Elektrodensegmenten (B3) von der Größe der Elektrodensegmente von mindestens einem anderen Paar von Segmenten (A3, C3) unterscheidet.

3. Elektrodenpaar nach Anspruch 1, wobei die Größe aller Elektrodensegmente (A2, B2, C2) dieselbe ist.

4. Elektrodenpaar nach Ansprüchen 1 bis 3, wobei elektrisch isolierendes Material oder Dunkelraum zwischen den benachbarten Segmenten von mindestens einem Paar von benachbarten Elektrodensegmenten vorgesehen ist.

5. Elektrodenpaar nach Ansprüchen 1 bis 4, wobei alle der Segmente der ersten und der zweiten gleichartig segmentierten Elektroden nicht in direktem elektrischen Kontakt miteinander stehen.

6. Elektrodenpaar nach Ansprüchen 1 bis 5, wobei die erste und die zweite gleichartig segmentierte Elektrode mit Mitteln zur Kühlung versehen sind.

7. Elektrodenpaar nach Ansprüchen 1 bis 6, wobei mindestens ein Elektrodensegment mit einem Mittel zur Kühlung versehen ist, das von mindestens einem anderen Mittel zur Kühlung eines anderen Elektrodensegments getrennt ist.

8. Elektrodenpaar nach Ansprüchen 1 bis 7, wobei die erste und die zweite segmentierte Elektrode mindestens ein Paar von Blindelementen umfassen.

9. Elektrodenpaar nach Ansprüchen 1 bis 8, wobei mindestens ein Elektrodensegment mit dedizierten Mitteln zur Kühlung versehen ist.

10. Elektrodenpaar nach Ansprüchen 1 bis 9, wobei mindestens ein Elektrodensegment der gleichartig segmentierten Elektroden zwei Elektrodenuntersegmente umfasst.

11. Lineare Hohlkathoden-Plasmaquelle, die mindestens ein Elektrodenpaar nach Ansprüchen 1 bis 10 umfasst.

12. Lineare Hohlkathoden-Plasmaquelle nach Anspruch 11, die eine oder mehrere Leistungsquellen umfasst, die ein oder mehrere Paare von Elektrodensegmenten mit einer elektrischen Leistung versorgen.

13. Lineare Hohlkathoden-Plasmaquelle nach Anspruch 12, die eine Leistungsquelle umfasst, die jedes Paar von Elektrodensegmenten mit einer elektrischen Leistung versorgt.

14. Lineare Hohlkathoden-Plasmaquelle nach Anspruch 12, die für jedes Paar von Elektrodensegmenten eine individuelle Leistungsquelle umfasst, die jedes Elektrodensegment mit einer individuellen elektrischen Leistung versorgt.

15. Lineare Hohlkathoden-Plasmaquelle nach Ansprüchen 11 bis 14, wobei mindestens ein Elektrodensegment mit einem dedizierten Mittel zur Kühlung versehen ist, das von mindestens einem anderen Mittel zur Kühlung von einem anderen Elektrodensegment getrennt kontrolliert wird.

16. Lineare Hohlkathoden-Plasmaquelle nach Ansprüchen 12 bis 15, wobei mindestens ein Paar von Elektrodensegmenten mit einer elektrischen Leistung versorgt wird und mindestens ein anderes Paar von Elektrodensegmenten mit einer anderen elektrischen Leistung versorgt wird.

17. Lineare Hohlkathoden-Plasmaquelle nach Ansprüchen 12 bis 15, wobei jedes Paar von Elektrodensegmenten mit der gleichen elektrischen Leistung versorgt wird.

18. Verfahren zum Behandeln oder Beschichten einer Substratoberfläche, das Folgendes umfasst:
a. Bereitstellen einer Vakuumkammer, die eine lineare Hohlkathoden-Plasmaquelle nach Ansprüchen 11 bis 17 umfasst,
b. Einlassen eines plasmabildenden Gases durch die Einlässe des plasmabildenden Gases der gleichartig segmentierten Elektroden der Plasmaquelle,
c. Zuführen von elektrischer Leistung zu einem oder mehreren Paaren von Elektrodensegmenten, um somit einen Plasmavorhang zwischen deren jeweiligen Auslässen zu erzeugen,
d. optional, Einlassen eines Beschichtungs-Precursorgases in den erzeugten Plasmavorhang bzw. die erzeugten Plasmavorhänge,
e. Einführen eines Substrats in den erzeugten Plasmavorhang bzw. in die erzeugten Plasmavorhänge.

19. Verfahren zum kontinuierlichen Steuern der Plasmadichteverteilung über die Länge einer linearen Plasmaquelle, das Folgendes umfasst:
a. Bereitstellen einer Vakuumkammer, die eine lineare Hohlkathoden-Plasmaquelle nach Ansprüchen 11 bis 16 umfasst,
b. Einlassen eines plasmabildenden Gases durch die Einlässe des plasmabildenden Gases der gleichartig segmentierten Elektroden der Plasmaquelle,
c. Zuführen von elektrischer Leistung zu einem und mindestens einem anderen Paar von Elektrodensegmenten, um somit Plasmavorhänge zwischen deren jeweiligen Auslässen zu erzeugen,
d. Einstellen der Parameter der dem einen Paar von Elektrodensegmenten zugeführten elektrischen Leistung, unabhängig von den Parametern der dem mindestens einen anderen Paar von Elektrodensegmenten zugeführten elektrischen Leistung.

20. Verfahren zum Steuern der Gleichmäßigkeit einer Oberflächenbehandlung, das Folgendes umfasst:
a. Bereitstellen einer Vakuumkammer, die eine lineare Hohlkathoden-Plasmaquelle nach Ansprüchen 11 bis 16 umfasst,
b. Einlassen eines plasmabildenden Gases durch die Einlässe des plasmabildenden Gases der gleichartig segmentierten Elektroden,
c. Zuführen von elektrischer Leistung zu einem und mindestens einem anderen Paar von Elektrodensegmenten, um somit einen Plasmavorhang zwischen deren jeweiligen Auslässen zu erzeugen,
d. Einstellen der Parameter der dem einen Paar von Elektrodensegmenten zugeführten elektrischen Leistung, unabhängig von den Parametern der dem mindestens einen anderen Paar von Elektrodensegmenten zugeführten elektrischen Leistung,
e. Einführen eines Substrats in die erzeugten Plasmavorhänge.

21. Verfahren zum kontinuierlichen Steuern der Gleichmäßigkeit eines Dünnfilmabscheidungsprozesses, das Folgendes umfasst:
a. Bereitstellen einer Vakuumkammer, die eine lineare Hohlkathoden-Plasmaquelle nach Ansprüchen 11 bis 16 umfasst,
b. Einlassen eines plasmabildenden Gases durch die Einlässe des plasmabildenden Gases der gleichartig segmentierten Elektroden,
c. Zuführen von elektrischer Leistung zu einem und mindestens einem anderen Paar von Elektrodensegmenten, um somit einen Plasmavorhang zwischen deren jeweiligen Auslässen zu erzeugen,
d. Einstellen der Parameter der dem einen Paar von Elektrodensegmenten zugeführten elektrischen Leistung, unabhängig von den Parametern der dem mindestens einen anderen Paar von Elektrodensegmenten zugeführten elektrischen Leistung,
e. Richten eines Precursorgases auf die erzeugten Plasmavorhänge,
f. Einführen eines Substrats in die erzeugten Plasmavorhänge.

## Revendications

1. Paire d'électrodes, comprenant des première et deuxième électrodes (21, 22) pareillement segmentées, les première et deuxième électrodes (21, 22) pareillement segmentées
a. possédant la morphologie et la composition souhaitées pour l'émission d'électrons et la génération et la stabilité de plasma,
i. le plasma généré étant un plasma par cathode creuse,
b. étant allongées suivant une direction longitudinale,
c. étant de forme allongée et de dimension sensiblement identiques et adjacentes l'une à l'autre, leurs directions longitudinales étant parallèles entre elles,
d. étant chacune divisées perpendiculairement à leur longueur en le même nombre d'au moins deux segments (21A, 21B, 21C et 22A, 22B, 22C),
i. chaque segment de la première électrode (21A, 21B, 21C) étant en regard d'un segment pareillement dimensionné de la deuxième électrode (22A, 22B, 22C), et
ii. chaque segment de la première électrode et son segment en regard (21A et 22A ; 21B et 22B ; 21C et 22C) de la deuxième électrode formant une paire de segments (A2, B2, C2) d'électrode.

2. Paire d'électrodes selon la revendication 1, dans laquelle la dimension des segments d'au moins une paire de segments (B3) d'électrode est différente de la dimension des segments d'électrode d'au moins une autre paire de segments (A3, C3).

3. Paire d'électrodes selon la revendication 1, dans laquelle la dimension de tous les segments (A2, B2, C2) d'électrode est la même.

4. Paire d'électrodes selon les revendications 1 à 3, dans laquelle un matériau électriquement isolant ou un espace sombre est prévu entre les segments voisins d'au moins une paire de segments d'électrode voisins.

5. Paire d'électrodes selon les revendications 1 à 4, dans laquelle tous les segments des première et deuxième électrodes pareillement segmentées ne sont pas au contact électrique direct les uns des autres.

6. Paire d'électrodes selon les revendications 1 à 5, dans laquelle les première et deuxième électrodes pareillement segmentées sont pourvues de moyens de refroidissement.

7. Paire d'électrodes selon les revendications 1 à 6, dans laquelle au moins un segment d'électrode est pourvu d'un moyen de refroidissement qui est distinct d'au moins un autre moyen de refroidissement d'un autre segment d'électrode.

8. Paire d'électrodes selon les revendications 1 à 7, dans laquelle les première et deuxième électrodes segmentées comprennent au moins une paire d'éléments fictifs.

9. Paire d'électrodes selon les revendications 1 à 8, dans laquelle au moins un segment d'électrode est pourvu d'un moyen de refroidissement dédié.

10. Paire d'électrodes selon les revendications 1 à 9, dans laquelle au moins un segment d'électrode des électrodes pareillement segmentées comprend deux sous-segments d'électrode.

11. Source de plasma linéaire à cathode creuse, comprenant au moins une paire d'électrodes selon les revendications 1 à 10.

12. Source de plasma linéaire à cathode creuse selon la revendication 11, comprenant une ou plusieurs sources d'alimentation fournissant une alimentation électrique à une ou plusieurs paires de segments d'électrode.

13. Source de plasma linéaire à cathode creuse selon la revendication 12, comprenant une source d'alimentation fournissant une alimentation électrique à chaque paire de segments d'électrode.

14. Source de plasma linéaire à cathode creuse selon la revendication 12, comprenant, pour chaque paire de segments d'électrode, une source d'alimentation individuelle fournissant une alimentation électrique individuelle à chaque segment d'électrode.

15. Source de plasma linéaire à cathode creuse selon les revendications 11 à 14, dans laquelle au moins un segment d'électrode est pourvu d'un moyen de refroidissement dédié qui est commandé séparément d'au moins un autre moyen de refroidissement d'un autre segment d'électrode.

16. Source de plasma linéaire à cathode creuse selon les revendications 12 à 15, dans laquelle au moins une paire de segments d'électrode est alimentée par une alimentation électrique et au moins une autre paire de segments d'électrode est alimentée par une autre alimentation électrique.

17. Source de plasma linéaire à cathode creuse selon les revendications 12 à 15, dans laquelle chaque paire de segments d'électrode est alimentée par la même alimentation électrique.

18. Procédé de traitement ou de revêtement d'une surface de substrat, comprenant :
a. la fourniture d'une chambre à vide comprenant une source de plasma linéaire à cathode creuse selon les revendications 11 à 17,
b. l'injection d'un gaz plasmagène à travers les entrées de gaz plasmagène des électrodes pareillement segmentées de la source de plasma,
c. l'alimentation par une alimentation électrique d'une ou de plusieurs paires de segments d'électrode de manière à générer un rideau de plasma entre leurs sorties respectives,
d. éventuellement, l'injection d'un gaz précurseur de revêtement dans le(s) rideau(x) de plasma généré(s),
e. l'introduction d'un substrat dans le(s) rideau(x) de plasma généré(s).

19. Procédé de commande en continu de la distribution de densité de plasma sur toute la longueur d'une source de plasma linéaire, comprenant :
a. la fourniture d'une chambre à vide comprenant une source de plasma linéaire à cathode creuse selon les revendications 11 à 16,
b. l'injection d'un gaz plasmagène à travers les entrées de gaz plasmagène des électrodes pareillement segmentées de la source de plasma,
c. l'alimentation par une alimentation électrique d'une et d'au moins une autre paire de segments d'électrode de manière à générer des rideaux de plasma entre leurs sorties respectives,
d. la fixation des paramètres de l'alimentation électrique alimentant ladite une paire de segments d'électrode indépendamment des paramètres de l'alimentation électrique alimentant ladite au moins une autre paire de segments d'électrode.

20. Procédé de commande de l'uniformité d'un traitement de surface, comprenant :
a. la fourniture d'une chambre à vide comprenant une source de plasma linéaire à cathode creuse selon les revendications 11 à 16,
b. l'injection d'un gaz plasmagène à travers les entrées de gaz plasmagène des électrodes pareillement segmentées,
c. l'alimentation par une alimentation électrique d'une et d'au moins une autre paire de segments d'électrode de manière à générer un rideau de plasma entre leurs sorties respectives,
d. la fixation des paramètres de l'alimentation électrique alimentant ladite une paire de segments d'électrode indépendamment des paramètres de l'alimentation électrique alimentant ladite au moins une autre paire de segments d'électrode,
e. l'introduction d'un substrat dans les rideaux de plasma générés.

21. Procédé de commande en continu de l'uniformité d'un processus de dépôts de couches minces, comprenant :
a. la fourniture d'une chambre à vide comprenant une source de plasma linéaire à cathode creuse selon les revendications 11 à 16,
b. l'injection d'un gaz plasmagène à travers les entrées de gaz plasmagène des électrodes pareillement segmentées,
c. l'alimentation par une alimentation électrique d'une et d'au moins une autre paire de segments d'électrode de manière à générer un rideau de plasma entre leurs sorties respectives,
d. la fixation des paramètres de l'alimentation électrique alimentant ladite une paire de segments d'électrode indépendamment des paramètres de l'alimentation électrique alimentant ladite au moins une autre paire de segments d'électrode,
e. la projection d'un gaz précurseur en direction des rideaux de plasma générés,
f. l'introduction d'un substrat dans les rideaux de plasma générés.
